# EUROPÄISCHE PATENTSCHRIFT

(11) **EP 1 761 696 B1**
(45) Veröffentlichungstag und Bekanntmachung des Hinweises auf die Patenterteilung: **20.01.2010**
(21) Anmeldenummer: 04740123.7
(22) Anmeldetag: 21.06.2004
(51) Int. Cl.: F02D 41/24, G01D 18/00, F02D 41/34, G01R 29/02, F02D 41/06, F01L 1/344

(54) **VERFAHREN UND SYSTEM ZUR BEREITSTELLUNG EINES VERBESSERTEN PHASENSIGNALS EINES PHASENSENSORS AN EINER NOCKENWELLE EINER BRENNKRAFTMASCHINE**
METHOD AND SYSTEM FOR PROVIDING AN IMPROVED PHASE SIGNAL OF A PHASE SENSOR THAT IS LOCATED ON A CAMSHAFT OF AN INTERNAL COMBUSTION ENGINE
PROCEDE ET SYSTEME POUR METTRE A DISPOSITION UN SIGNAL DE PHASE AMELIORE PROVENANT D'UN DETECTEUR DE PHASE INSTALLE SUR UN ARBRE A CAMES D'UN MOTEUR A COMBUSTION INTERNE

(30) Priorität: 27.05.2004 WO PCT/EP2004/005747; 17.06.2004 WO PCT/EP2004/006554
(43) Veröffentlichungstag der Anmeldung: 14.03.2007
(73) Patentinhaber: ROBERT BOSCH GMBH, 70469 Stuttgart (DE)
(72) Erfinder: STEINRUECKEN, Heinrich, 71640 Ludwigsburg (DE); WALTER, Klaus, 74321 Bietigheim-Bissingen (DE); RETTIG, Rasmus, 70839 Gerlingen (DE); GINTNER, Klemens, 76275 Ettlingen (DE)
(86) Internationale Anmeldenummer: PCT/EP2004/006686
(87) Internationale Veröffentlichungsnummer: WO 2005/119041

(56) Entgegenhaltungen:
- US-A- 5 417 187
- US-A- 5 692 488
- US-A1- 2003 000 498

## Beschreibung

### Stand der Technik

Die Erfindung betrifft ein Verfahren zur Bereitstellung eines verbesserten Phasensignals eines Phasensensors an einer Nockenwelle einer Brennkraftmaschine unmittelbar nach dem Einschalten des Phasensensors und/oder der Brennkraftmaschine. Der Phasensensor tastet dabei Winkelmarken eines drehfest mit der Nockenwelle verbundenen Geberrads ab. Außerdem tastet ein Kurbelwellensensor Winkelmarken eines drehfest mit der Kurbelwelle verbundenen Geberrads ab.

Bei Mehrzylinder-Brennkraftmaschinen mit elektronischer Einspritzung wird üblicherweise in der Motorsteuerung berechnet, wann und wie viel Kraftstoff pro Zylinder eingespritzt werden soll und wann der optimale Zündzeitpunkt ist. Damit diese Berechnungen in korrekter Weise durchgeführt werden können, muss die jeweilige Stellung der Kurbel- beziehungsweise Nockenwelle der Brennkraftmaschine bekannt sein. Aus der EP-PS-0017933 ist beispielsweise bekannt, dass die Kurbel- und Nockenwelle mit je einer Scheibe verbunden sind, auf deren Oberfläche wenigstens eine Bezugsmarke angebracht ist, wobei auf der Kurbelwellenscheibe zusätzlich eine Vielzahl gleichartiger Markierungen, auch Inkremente genannt, angebracht sind.

Die beiden sich drehenden Scheiben werden von feststehenden Sensoren abgetastet. Aus der zeitlichen Abfolge der von den Sensoren gelieferten Signalen in Form von Impulsen lässt sich eine eindeutige Aussage über die Stellung von Kurbel- und Nockenwelle gewinnen und es können in der Motorsteuerung entsprechende Ansteuersignale für die Einspritzung oder Zündung gebildet werden.

Aus der DE 41 41 713 A1 ist bekannt geworden, neben einem Geberrad der Kurbelwelle, das eine Scheibe mit einer Vielzahl von Markierungen und einer durch zwei fehlende Markierungen gebildete Referenz- beziehungsweise Bezugsmarke aufweist, ein Geberrad an der Nockenwelle vorzusehen. Dieses nockenwellenseitige Geberrad weist unterschiedlich lange, auf die Zylinderzahl abgestimmte, Markierungen auf, die das Phasensignal des Phasensensors abbildet. Das Phasensignal des Phasensensors wird zur Zylinderidentifikation herangezogen.

Aus der DE 43 10 460 A1 ist ferner bekannt geworden, im Start oder im Betrieb der Brennkraftmaschine aufgrund von mechanischen und elektrischen Toleranzen auftretende Abweichungen des Phasensignals zum Nockenwellensignal durch Vergleich mit zu erwartenden Werten oder Winkeln festzustellen und diese Abweichungen durch einen Lernvorgang zu korrigieren. Nach jedem Einschalten des Phasensensors beziehungsweise nach jedem Starten der Brennkraftmaschine ist eine derartige Korrektur von neuem durchzuführen.

Aus der US 2003/000498 A1 ist ein Verfahren zur Bereitstellung eines verbesserten Phasensignals eines Phasensensors einer Nockenwelle bekannt, bei dem der Phasensensor drehfest mit der Nockenwelle verbundene Winkelmarken abtastet und während des Anlaufs einen Kalibriervorgang durchführt.

### Vorteile der Erfindung

Das erfindungsgemäße Verfahren mit den Merkmalen des Anspruchs 1 hat den Vorteil, dass nach einem erneuten Einschalten des Phasensensors beziehungsweise nach einem erneuten Start der Brennkraftmaschine ein verbessertes
Phasensignal des Phasensensors zur Verfügung steht. Dies wird folgendermaßen erreicht:
a) Nach dem ersten Einschalten des Phasensensors beziehungsweise des Verbrennungsmotors wird wie folgt vorgegangen:
   a.1) Ermitteln der Anlauf-Signallage des Phasensignals während eines Kallibiervorgangs des Phasensensors auf der Basis des Kurbelwellensignals über mehrere Winkelmarken des Geberrads der Nockenwelle hinweg, wobei während des Kallibiervorgangs das Phasensignals schrittweise um Adaptionswerte korrigiert wird, bis eine vorgegebene Soll-Signallage bzw. Normal-Signallage erreicht ist,
   a.2) Ermitteln der Normal-Signallage des Phasensignals auf der Basis des Kurbelwellensignals nach dem Anlaufen der Brennkraftmaschine und des abgeschlossenen Kalibriervorgangs im Phasengeber,
   a.3) Bestimmen von Winkelfehlern aus der Differenz zwischen der Anlauf-Signallage und der Normal-Signallage;
   a.4) Ablegen von auf den Winkelfehlern basierenden Korrekturwerten in einem nicht flüchtigen Speicher insbesondere in der Motorsteuerung;
b) Beim erneuten Einschalten des Phasensensors bzw. Brennkraftmaschine:
   b.1) Korrigieren des von der Motorsteuerung erfassten Phasensignals während des Kalibiervorgangs des Phasengebers um die insbesondere in der Motorsteuerung abgelegten Korrekturwerte, so dass nach dem erneuten Einschalten ein verbessertes Phasensignal zur Verfügung steht.

Aufgrund des nicht flüchtigen Speicherns der Korrekturwerte stehen die Korrekturwerte bei einem erneuten Starten der Brennkraftmaschine sofort zur Verfügung. Grundsätzlich steigen die Anforderungen an ein genaues Signal des Phasensensors, insbesondere beim Starten der Brennkraftmaschine. Eine genaue Winkellage des Phasensignals zum Kurbelwellensignal gleich nach dem Starten der Brennkraftmaschine führt zu einer besseren und optimierten Steuerung der Einspritzung, Zündung und Nockenwellenverstellsystemen, was letztendlich zu einem besseren Abgasverhalten der Brennkraftmaschine im Anlaufbetrieb führt.

Es hat sich herausgestellt, dass die Abweichung der Anlauf-Signallage des auf dem Kurbelwellensignal basierenden Phasensignals zur Normal-Signallage insbesondere auf folgenden Parametern beruht: Luftspalt zwischen dem Geberrad an der Nockenwelle und dem Phasensensor, Temperatur und Drehzahl der Nockenwelle/Kurbelwelle. Einen besonders großen Einfluss trägt dabei der Luftspalt, der von den Einbauverhältnissen abhängt und von Brennkraftmaschine zu Brennkraftmaschine verschieden sein kann. Durch das erfindungsgemäße Verfahren kann bei einem erneuten Einschalten des Phasensensors, beziehungsweise der Brennkraftmaschine, insbesondere der Einfluss des Luftspalts korrigiert werden.

Das Verfahren wird insbesondere dann durchgeführt, wenn die Kurbelwelle und der Nockenwelle synchronisiert laufen. Idealerweise erfolgt das Korrigieren des Phasensignals gemäß Schritt b.1) derart, dass das korrigierte Phasensignal während des Kalibiervorgangs auf der Basis des Kurbelwellensignals eine korrigierte Anlauf-Signallage ergibt, die im wesentlichen der Normal-Signallage entspricht.

Der Kalibiervorgang bzw. die Adaption während des Kalibriervorgangs ist dabei keine von der Motorsteuerung ausgehende aktive Aktion. Die Motorsteuerung kann diese "Adaption" nicht beeinflussen. Die Veränderung der Signallage des Phasensignals ist ausschließlich von dem im Phasensensor ablaufenden Kalibriervorgang abhängig.

Erfindungsgemäß kann vorgesehen sein, dass die Soll-Signallage bzw. Normal-Signallage gemäß Schritt a.1) dann erreicht ist, wenn das Phasensignal auf einer Schaltschwelle des Phasensensors beruht, die im Bereich eines bestimmten Prozentsatzes des maximalen vom Phasensensor erfassten Signals liegt. Der verwendete Phasensensor hat dabei eine Einschalt-Schaltschwelle, die bei einem vergleichsweise geringen Eingangssignal des Sensors liegt. Dies ist deshalb erforderlich, um auch ein sofortiges Schalten von Sensoren nach dem Einschalten zu ermöglichen, bei denen ein vergleichsweise großer Luftspalt zwischen dem Sensor und der Winkelmarke des Geberrades vorhanden ist. Da der Luftspalt je nach Einbau unterschiedlich sein kann, ist vorgesehen, dass der Phasensensor sich selbst kalibriert. Dabei wird die Schaltschwelle in einen vom maximalen Eingangssignalhub des Sensors abhängigen Bereich schrittweise verschoben. Es hat sich gezeigt, dass bei ca. 70% des maximalen vom Sensor erfassten analogen Signalhubs eine günstige Schaltschwelle liegt. Während des Kalibiervorgangs wird folglich die voreingestellte Schaltschwelle des Sensors auf einen Wert von insbesondere ca. 70% des maximalen detektierten Werts schrittweise verschoben. Erreicht die Schaltschwelle den vorgegebenen Wert, ist die Soll-Signallage bzw. die Normal-Signallage erreicht. Der Kalibiervorgang ist dann abgeschlossen. Die Dauer des Kalibriervorganges hängt dabei von der Größe des Luftspalts ab.

Der Kalibriervorgang erfolgt während des Anlaufens der Brennkraftmaschine. Das Anlaufen der Brennkraftmaschine ist vorteilhafterweise nach acht Arbeitsspielen abgeschlossen. Der Kalibriervorgang ist vorteilhafterweise dann spätestens ebenfalls nach acht Arbeitsspielen abgeschlossen; er kann jedoch auch schon vorher, je nach Größe des Luftspalts, abgeschlossen sein. Dadurch wird erreicht, dass die Anlauf-Signallage in kleinen Schritten an die Normal-Signallage herangeführt wird, wodurch ungewollte, zu große Signalabweichungen vermieden werden. Es ergibt sich hierdurch ein stabiles und systematisches Verhalten.

Ein erfindungsgemäßes Verfahren kann sich dadurch auszeichnen, dass die Korrekturwerte aus einem maximalen Winkelfehler bei der ersten abgetasteten Winkelmarke und aus um die Adaptionswerte korrigierte weitere Winkelfehler bei weiteren abgetasteten Winkelmarken gebildet werden. Die Korrekturwerte können dabei den jeweiligen Winkelfehlern entsprechen. Die Korrekturwerte können allerdings auch von den Winkelfehlern abhängige Werte sein, beispielsweise um Temperatur oder Drehzahl korrigierte Werte. Anstelle von den Winkelfehlern können auch für die Winkelfehler charakteristische Werte Verwendung finden, beispielsweise ist es denkbar, eine auf den Winkelfehlern basierende oder an die Winkelfehler angenäherte Geraden zu verwenden.

Ein erfindungsgemäßes Verfahren kann sich dadurch auszeichnen, dass beim mehrfach erneuten Einschalten des Phasensensors bzw. der Brennkraftmaschine nach Schritt b.1) die korrigierte Anlauf-Signallage mit der auf den bereist gespeicherten Korrekturwerten beruhenden zu erwartenden Anlauf-Signallage verglichen wird und bei mehrfachem Wiederholen eine Mittelwertbildung, insbesondere eine gleitende Mittelwertbildung, der gemäß Schritt a.4) abzulegenden Korrekturwerte erfolgt. Bei jedem erneuten Einschalten des Phasensensors, beziehungsweise der Brennkraftmaschine, werden folglich die Korrekturwerte abgespeichert, angepasst und gelernt. Die beim wiederum erneuten Einschalten des Phasensensors, beziehungsweise der Brennkraftmaschine, zu verwendenden Korrekturwerte werden folglich durch die jeweilige Mittelwertbildung optimiert.

Insbesondere können die Winkelmarken am Geberrad der Nockenwelle als Flanken von Segmenten zur Erzeugung von High- und Low-Phasen-Signalen ausgebildet sein. Insbesondere sind vier Segmente vorgesehen, die jeweils eine positive und eine negative Flanke aufweisen. Dadurch wird eine eindeutige Zuordnung der Drehstellung des Geberrads der Nockenwelle innerhalb eines Arbeitsspiels möglich. Dann ist es vorteilhafterweise möglich, die Winkelfehler aufgrund der Abweichung der Anlauf-Flankenlage zur Normal-Flankenlage zu bestimmen. Dabei können lediglich die negativen oder positiven Flanken berücksichtigt werden. Mit Kenntnis der absoluten Lage dieser Flanken, z.B. im Abstand von 90°NW, können an jeder Flanke die Ist-Phasenlage bestimmt werden.

Wie bereits angesprochen, kann es vorteilhaft sein, die Adaption während des Kalibriervorgangs in mehreren kleinen Schritten durchzuführen. Die Adaption zwischen zwei Flanken kann dabei auf einen maximalen Wert begrenzt sein, wobei dieser maximale Wert insbesondere im Bereich von ±2° und ±0,1°, und insbesondere im Bereich von ±0,2° bis ±0,75°, und insbesondere im Bereich von ±0,25°, liegt. Gerade der Bereich von ±0,25° hat sich als besonders vorteilhaft herausgestellt. Soll eine Differenz der Anlauf-Flankenlage zu der Normal-Flankenlage von beispielsweise 2,5° an der Nockenwelle korrigiert werden, erfolgt dies vorzugsweise über zehn bis vierzehn negative oder positive Flankenwechsel bei einer maximalen Adaption von 0,25° zwischen zwei Flankenwechseln. Typischerweise sind pro Arbeitsspiel insgesamt vier negative Flankenwechsel vorgesehen; eine Adaption erfolgt dann über drei bis vier Arbeitsspiele.

Das Ablegen der Korrekturwerte in einem nicht flüchtigen Speicher kann insbesondere in der Motorsteuerung erfolgen. Der nicht flüchtige Speicher kann beispielsweise ein Dauerram-Speicher, insbesondere ein EEPROM oder ein Flash Speicher, sein.

Eine weitere, bevorzugte Ausführungsform der Erfindung zeichnet sich dadurch aus, dass die Korrekturwerte durch eine an die Winkelfehler angenäherte Gerade abgebildet werden. Hierdurch wird Speicherplatz eingespart, da nicht für jeden Flankenwechsel ein jeweiliger Korrekturwert in dem nicht flüchtigen Speicher abzulegen ist. Die Gerade kann beispielsweise über eine lineare Regression oder über zwei ausgewählte Wertepaare definiert sein. Insofern genügt es, lediglich die beiden definierten Werte im nicht flüchtigen Speicher zu halten. Zur Plausibilisierung der jeweiligen Werte können noch zusätzliche Mechanismen eingesetzt werden, die beispielsweise zulässige Bereiche der Werte prüfen.

Vorteilhafterweise erfolgt die Adaption und Korrektur unter definierten Bedingungen der Nockenwelle. Bei einer Nockenwellenverstellung wird diese Verstellung berücksichtigt. Ferner erfolgt die Adaption nur dann, wenn keine detektierbaren Systemstörungen vorliegen.

Eine andere Ausführungsform der Erfindung zeichnet sich dadurch aus, dass über einen Vergleich der ermittelten Winkelfehlern bzw. Korrekturwerten mit für dem für den Phasengeber typischen Verhalten für die verschieden Luftspalte verglichen wird. Über eine Korrelation der beiden Werte lässt sich der am jeweiligen Motorexemplar anzutreffende Luftspalt ermitteln. Darüber können weitere Luftspaltabhängigkeiten kompensiert werden. Weiterhin werden daraus entsprechende Diagnose- und/oder Korrekturfunktionen aufgesetzt oder unterstütz. Hierdurch kann aufgrund der Winkelfehlern bzw. der Korrekturwerte beispielsweise auf einen zu großen Luftspalt rückgeschlossen werden und entsprechende Hinweise z.B. am Bandende oder in der Werkstatt über nicht ordnungsgemäßen Einbau gegeben werden.

Die Erfindung betrifft außerdem ein System zur Durchführung des erfindungsgemäßen Verfahrens, eine Motorsteuerung zur Durchführung des erfindungsgemäßen Verfahrens sowie ein Computerprogramm für eine derartige Motorsteuerung.

### Zeichnung

Die Erfindung ist in der Zeichnung dargestellt und wird in der nachfolgenden Beschreibung näher erläutert. In der Zeichnung zeigen:
- Figur 1: eine grobe Übersicht über die Anordnung von Kurbel- und Nockenwelle samt den zugehörigen Sensoren und Motorsteuerung, in der die Berechnungen zur Steuerung der Einspritzung und Zündung das erfindungsgemäße Verfahren ablaufen;
- Figur 2: Steuersignale, beziehungsweise von Sensoren registrierte Signale, während der Startphase der Brennkraftmaschine über die Zeit aufgetragen;
- Figur 3: Adaption der Differenz der Anlauf-Signallage zu der Normal-Signallage über mehrere Flankenwechsel aufgetragen beim ersten Einschalten des Phasensensors beziehungsweise der Brennkraftmaschine, abhängig vom Luftspalt zwischen Geberrad und Phasensensor;
- Figur 4: Korrigieren des Phasensignals um die Korrekturwerte beim erneuten Einschalten des Phasensensors beziehungsweise der Brennkraftmaschine;
- Figur 5: das analoge Eingangssignal eines Phasensensors;
- Figur 6: die schrittweise Adaption des Nockenwellensignals über mehrere Flankenwechsel; und
- Figur 7: den Adaptions-, Speicher- und Korrekturvorgang.

### Beschreibung der Ausführungsbeispiele

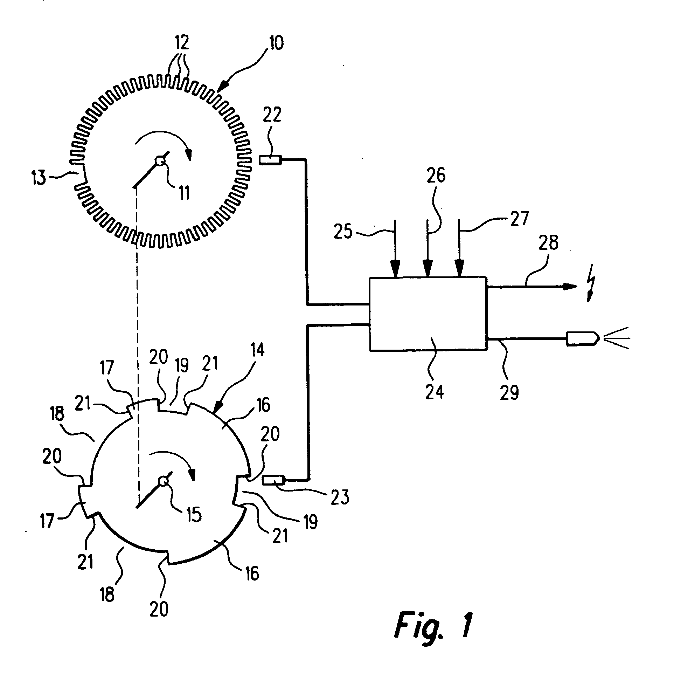

In Figur 1 sind in einer groben Übersicht die wesentlichsten Elemente der vorliegenden Erfindung in Verbindung mit einer Brennkraftmaschine samt einer Motorsteuerung dargestellt. Eine solche Anordnung ist prinzipiell bereits bekannt (DE 43 10 460 A1).

In Figur 1 ist mit 10 ein Geberrad bezeichnet, dass starr mit der Kurbelwelle 11 der Brennkraftmaschine verbunden ist und an seinem Umfang eine Vielzahl gleichartiger Winkelmarken 12 aufweist. Neben diesen gleichartigen Winkelmarken 12 ist eine Bezugsmarke 13 vorgesehen, die beispielsweise durch zwei fehlende Winkelmarken gebildet wird. Üblicherweise sind insgesamt 60-2 Winkelmarken über den gesamten Umfang von 360° vorgesehen.

Ein zweites Geberrad 14 ist mit der Nockenwelle 15 der Brennkraftmaschine verbunden und weist an seinem Umfang unterschiedlich lange Segmente auf, wobei die kürzeren Segmente mit 17 und die längeren Segmente mit 16 bezeichnet sind. Zwischen den Winkelmarken beziehungsweise Segmenten sind Zwischenräume vorgesehen, die längeren tragen das Bezugszeichen 18, die kürzeren das Bezugszeichen 19. Jedes Segment 16, 17 wird begrenzt von einer positiven Flanke 20 und einer negativen Flanke 21.

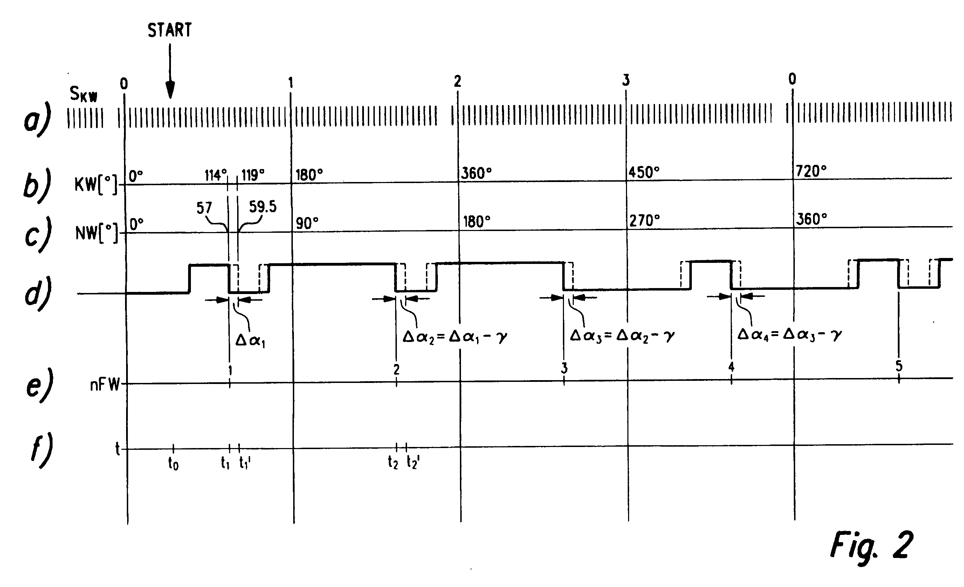

Das in der Figur 1 dargestellte Geberrad 14 ist für eine Brennkraftmaschine geeignet, die Anzahl der Segmente 16, 17 ist so gewählt, dass eine eindeutige Synchronisation innerhalb jeden Segmentes zusammen mit dem Referenzsignal auf der Kurbelwelle erlaubt. Diese Anordnung wird für Brennkraftmaschinen mit 4, 5, 6, 8 oder mehr Zylindern eingesetzt. Die genaue Anordnung der Winkelmarken sowie die Zuordnung der Segmente 16, 17 zu den Marken des Geberrads 10 der Kurbelwelle 11 ist so vorzunehmen, dass die in Figur 2 dargestellten Signalabläufe erhalten werden.

Das Geberrad 10 der Kurbelwelle 11 wird von einem Kurbelwellensensor 22 erfasst; das Geberrad 14 der Nockenwelle 15 von einem Phasensensor 23. Der Sensor 22ist beispielsweise ein induktiver Aufnehmer oder Hallsensoren, die beim Vorbeilaufen der Winkelmarken in den Sensoren Signale erzeugen. Der Sensor 23 ist ein aktiver Sensor, z.B. ein Hallsensor, der das oben beschriebene Kalibrierverhalten aufweist. Die erzeugten Signale werden der Motorsteuerung 24 zugeführt und dort weiterverarbeitet.

Die Motorsteuerung 24 erhält über die Eingänge 25, 26 und 27 weitere, für die Steuerung der Brennkraftmaschine erforderliche Eingangsgrößen, die von geeigneten Sensoren geliefert werden. Ausgangsseitig stellt die Motorsteuerung 24 Signale für die Zündung, Einspritzung und Nockenwellensteuerung für nicht näher bezeichnete Komponenten der Brennkraftmaschine zur Verfügung; die Ausgänge der Motorsteuerung 24 sind mit 28 und 29 bezeichnet.

In Figur 2 sind die von den Sensoren 22 und 23 gelieferten und bereits zu Rechtecksignalen aufbereiteten Signale, die in der Motorsteuerung 24 ausgewertet werden, über dem Kurbelwellenwinkel (Figur 2b) beziehungsweise dem Nockenwellenwinkel (Figur 2c) beziehungsweise über der Zeit t (Figur 2f) aufgetragen. Die Nockenwelle wird dabei mit halber Kurbelwellendrehzahl von der Kurbelwelle angetrieben.

Im Einzelnen ist in Figur 2a das vom Kurbelwellensensor 22 gelieferte und aufbereitete Kurbelwellensignal S_{KW} aufgetragen. Die Zahl der Winkelmarken beträgt 60-2; die fehlenden beiden Winkelmarken bilden die Referenz - oder Bezugsmarke 13. Da sich ein Arbeitsspiel der Brennkraftmaschine über zwei Kurbelwellenumdrehungen erstreckt, müssen mit der gewählten Anordnung zwei Mal 60-2 Impulse vom Kurbelwellengeber über ein Arbeitsspiel erzeugt werden.

In Figur 2b ist der Drehwinkel der Kurbelwelle über ein Arbeitsspiel, das heißt von 0° bis 720, dargestellt.

In Figur 2c ist der Drehwinkel der Nockenwelle dargestellt, der innerhalb eines Arbeitsspiels im Bereich von 0° bis 360° liegt.

In Figur 2d ist der Signalverlauf der Nockenwelle S_{NW} für eine 4-Zylinder Brennkraftmaschine dargestellt. Das Geberrad 14 der Nockenwelle 15 sieht zwei unterschiedliche Segmente 17, 18 vor, die im Signal zu unterschiedlichen Low- und High-Phasen führen. Da sowohl das Kurbelwellensignal als auch das Nockenwellensignal ausgewertet werden, können gleiche Segmente durch die vorhandene beziehungsweise nicht vorhandene Bezugsmarke 13 im Geberrad 10 der Kurbelwelle 11 unterschieden werden.

In Figur 2e sind die aus den negativen Flanken 21 resultierenden Flankenwechsel nFW am Geberrad 14 der Nockenwelle 15 über ein Arbeitsspiel dargestellt. Insgesamt ergeben sich pro Arbeitsspiel vier Flankenwechsel, die einen äquidistanten Winkelabstand von jeweils 90° zueinander aufweisen.

Beim erstmaligen Starten der Brennkraftmaschine ist insbesondere aufgrund eines variierenden, einbaubedingten Luftspalts zwischen dem Phasensensor 23 und den Segmenten 16, 17 zunächst ein ungenaues Signal S_{NW} an der Nockenwelle gegeben. Während des Anlaufens der Brennkraftmaschine wird über einen Kalibriervorgang von maximal vierundsechzig Flanken des Phasengeberrads 14, also insgesamt über maximal acht Arbeitsspiele bei einem 4-Zylindermotor, die Anlauf-Signallage des Phasensignals zum Kurbelwellensignal in eine Normal-Signallage adaptiert. Die Adaption erfolgt insbesondere durch Veränderung der Schaltschwelle des Phasensensors beim Erfassen der Flankenwechsel.

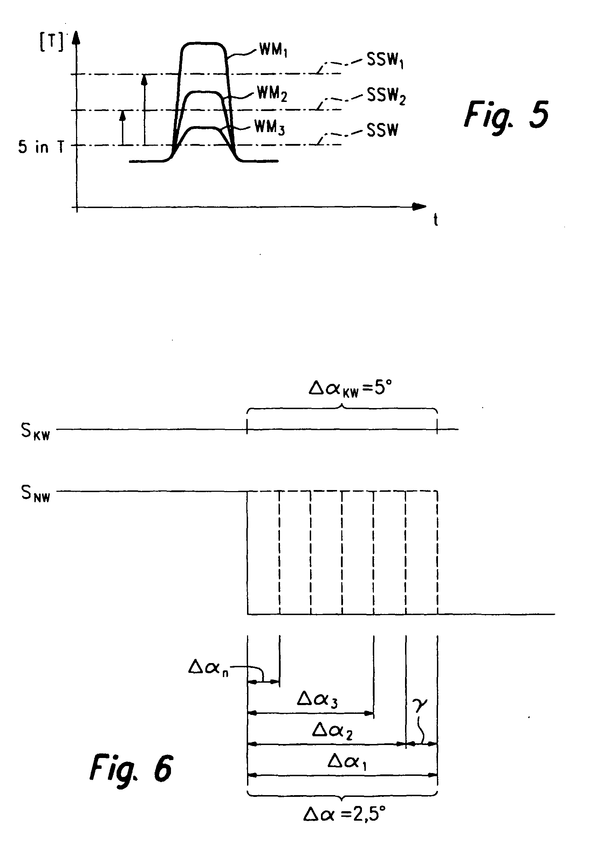

Eine derartige Veränderung der Schaltschwelle ist beispielhaft in der Figur 5 dargestellt. Über der Zeitachse ist das analoge Eingangssignal des Phasensensors in Tesla aufgetragen. Beim Passieren der Winkelmarke des Phasensensors ergibt sich je nach Größe des Luftspalts zwischen dem Phasensensor und der Winkelmarke ein unterschiedliches Winkelmarkensignal WM. In der Figur 5 sind beispielhaft drei verschieden große Winkelmarkensignale WM₁, WM₂ und WM₃ gezeigt. Das vergleichsweise starke Signal WM₁ resultiert aus einem vergleichsweise geringem Luftspalt. Bei dem Signal WM₂ ist der Luftspalt größer. Bei dem Signal WM₃ ist der Luftspalt noch größer; dieses Signal ist folglich am schwächsten. Um auf jeden Fall ein Schalten des Sensors aufgrund des erfassten Signals zu gewährleisten, ist die Schaltschwelle SSW des Phasensensors vergleichsweise nieder eingestellt, ein typischer Wert liegt bei ca. 5 mTeslar oberhalb des Signaloffsets.

Um einen optimalen und repräsentativen Schaltzeitpunkt zu erhalten wird die voreingestellte Schaltschwelle SSW vom Phasensensor auf einen Wert von ca. 70% des maximal detektierten Signals schrittweise verschoben. Gemäß Figur 5 erfolgt bei einem Signal WM₁ eine Verschiebung der voreingestellten Schaltschwelle SSW auf die für dieses Signal MW₁ optimale Schaltschwelle SSW₁. Bei einem Eingangssignal WM₂ erfolgt ein Verschieben der voreingestellten Schaltschwelle SSW auf den Wert der Nenn-Schaltschwelle SSW₂.

Das Adaptieren des voreingestellten Wertes SSW auf den jeweiligen insbesondere luftspaltabhängigen Wert SSW_{1, 2, ...} erfolgt abhängig vom Kalibrierverhalten des Phasensensors in kleinen Schritten um Winkelwerte (Adaptionswerte) χ, so lange bis die vorgesehene Schaltschwelle erreicht ist. Dann liegt die Normal-Signallage des Nockenwellensignals zum Kurbelwellensignal vor. Die Vorgabe der Adaptionsschrittweite ist dabei insbesondere durch die zulässige Schaltpegelverschiebung definiert. Daraus ergibt sich dann abhängig vom jeweiligen LS eine Adaptionsschrittweite auf Winkelbasis.

Die Adaption erfolgt unter bestimmten Randbedingungen, beispielsweise bei einer Nockenwellenverstellung in Spätposition. Vor der Adaption kann eine Temperaturkorrektur aufgrund im Steuergerät abgelegter Kennlinien erfolgen.

In der Figur 2d ist die Normal-Signallage des Signals S_{NW} an der Nockenwelle als durchgezogene Linie dargestellt. Punktiert dargestellt ist die Anlauf-Signallage, die von der Normal-Signallage aufgrund eines vorhandenen Luftspalts beispielsweise eine Winkelabweichung von Δα von 2,5° an der Nockenwelle beim ersten Flankenwechsel nFW = 1 aufweist. Das heißt die Flanke beim Flankenwechsel nFW = 1 weicht in der Anlauf-Signallage um 2,5° von der Normal-Signallage ab.

Figur 2f stellt die Zeitachse t dar. Beispielsweise wird die Brennkraftmaschine zum Zeitpunkt to gestartet. Zum Zeitpunkt t₁' detektiert der Phasensensor einen negativen Flankenwechsel unter Berücksichtigung eines Winkelfehlers Δα.

In der Figur 6 ist die Adaption des Nockenwellensignals in der Kalibrierphase über mehrere negative Flankenwechsel dargestellt. Bei jedem Flankenwechsel wird das Nockenwellensignal S_{NW} um den Wert χ verschoben, bis die optimale Schaltschwelle des Phasensensors, und damit die Normal-Signallage, erreicht ist.

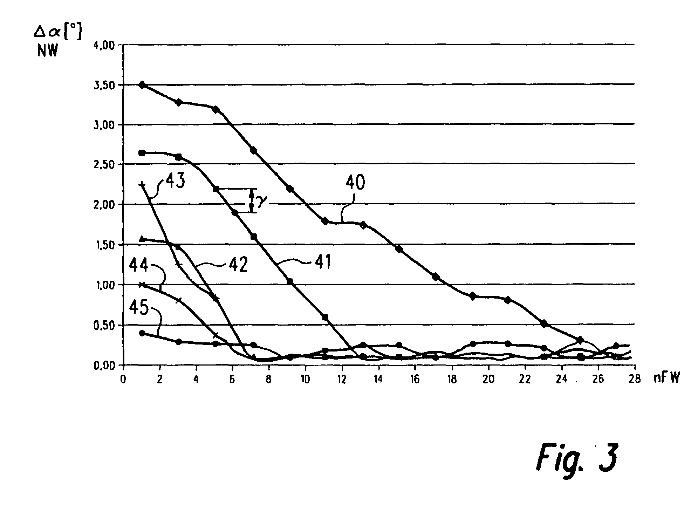

In Figur 3 ist das Kalibrierungverhalten des Phasensensors um den Winkelfehler Δα von der Normal-Signallage abweichenden Anlauf-Signallage über die Anzahl der Flankenwechsel nFW in der Kalibrierphase aufgetragen. Die Anlauf-Signallage wird aufgrund der Sensorkalibrierung bei jedem Flankenwechsel schrittweise um einen Wert χ adaptiert, bis letztendlich die Normal-Signallage erreicht ist.

Wie bereits erwähnt, hängt die Differenz der Anlauf-Signallage zu der Normal-Signallage, und damit der zu adaptierende Winkelfehler Δα, von der Größe des Luftspalts zwischen dem Phasengeberrad und dem Phasensensor der Nockenwelle ab. In Figur 3 sind insgesamt sechs Adaptionsverläufe der Winkelfehler Δα für verschieden große Luftspalte beispielhaft aufgetragen. Der Verlauf entlang der Linie 40 ergibt sich bei einem Luftspalt von 0,1 mm; der Verlauf der Linie 41 bei einem Luftspalt von 0,8 mm; der Verlauf der Linie 42 bei einem Luftspalt von 1,5 mm; der Verlauf der Linie 43 bei einem Luftspalt von 2,2 mm; der Verlauf der Linie 44 bei einem Luftspalt von 2,0 mm und der Verlauf der Linie 45 bei einem Luftspalt von 1,8 mm.

Beträgt der insgesamt zu adaptierende Winkelfehler Δα₁ an der Nockenwelle beispielsweise 2,5° (=5° an der Kurbelwelle) bei nFW=1, so ergibt sich eine Adaption des Winkelfehlers über insgesamt ca. 13 Flankenwechsel entlang der Linie 41.

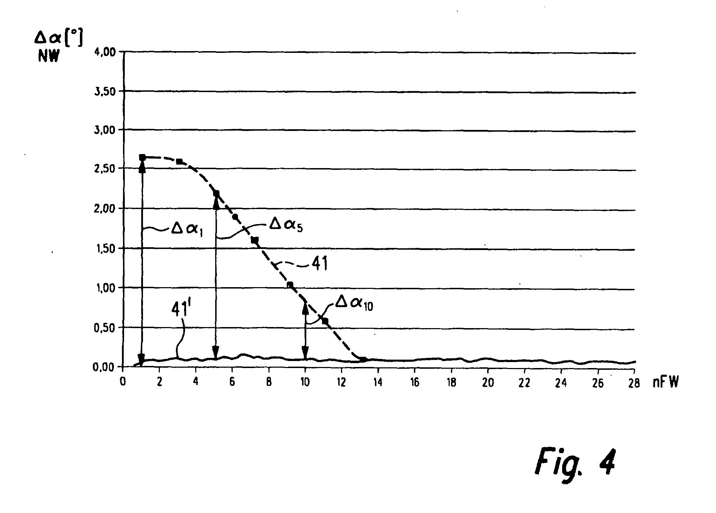

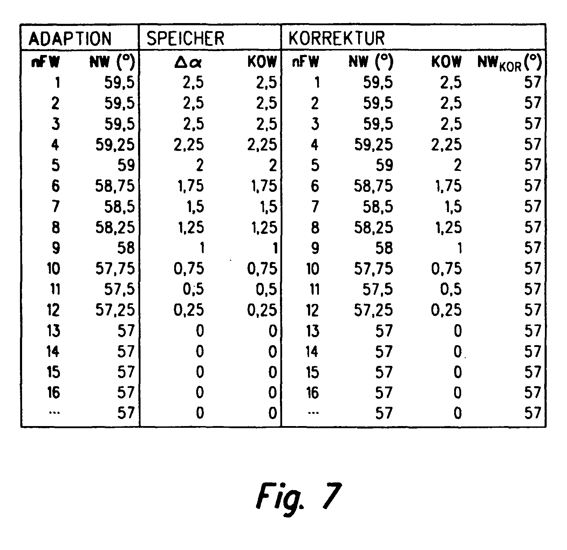

In der Figur 4 sind die Winkelfehler Δα₁ bei nFW=1, Δα₅ bei nFW=5 und Δα₁₀ bei nFW=10 für den Verlauf entlang der Linie 41 aus der Figur 3 beispielhaft dargestellt. Um einen sich aus einem Luftspalt von 0,8 mm ergebenden Winkelfehler von 2,5° an der Nockenwelle gemäß der Linie 41 auszugleichen, sind insgesamt dreizehn Flankenwechsel erforderlich. Zwischen jedem Flankenwechsel wird aufgrund der Kalibrierung das Phasensignal um den maximalen Adaptionswert χ=0,25° adaptiert, bis letztlich die Normal-Signallage des Phasensignals nach dreizehn Flankenwechseln erreicht ist. Die Werte der einzelnen Winkelfehler Δα sind der Figur 7 entnehmbar.

Die Adaptionsverlauf entlang der Linie 41 gemäß Figur 3 und 4 gilt für das erste Einschalten des Phasensensors beziehungsweise der Brennkraftmaschine. Ein erstes Einschalten kann dann vorliegen: Bei erstmaligem Starten der Brennkraftmaschine, bei gelöschtem nicht flüchtigen Speicher, beim Einbau oder Austausch des Phasensensors, bei ausgetauschter Motorsteuerung, bei Rücksetzen sämtlicher Funktionen in der Motorsteuerung.

Gemäß der Erfindung ist vorgesehen, dass auf den Winkelfehlern beruhende Korrekturwerte, das heißt insbesondere die Werte der Winkelfehler Δα₁ bei nFW=1, bzw. die korrigierten Winkelfehler Δα₂ bei nFW=2; Δα₃ bei nFW=3; bis Δαₙ bei nFW=n als Korrekturwerte KOW in einem nicht flüchtigen Speicher abgelegt werden, was ebenfalls der Figur 7 zu entnehmen ist.

Gemäß der Figur 1 beträgt der nicht adaptierte Winkel im Anlauf an der Nockenwelle NW = 59,5°. In der Normal-Signallage nach der Kalibrierung beträgt der NW = 57°. Die Adaption in der Kalibrierphase erfolgt also von einem Nockenwellenwinkel von NW = 59,5° bei nFW = 1 auf einen kalibrierten Nockenwellenwinkel NW = 57° bei nFW = 13. Insgesamt ergibt sich einen Winkelfehler von Δα₁ = 2,5° bei nFW=1 gemäß der Figur 4. Entsprechendes gibt Figur 7 wieder.

Nach Abschluss der Kalibrierphase und Erreichen der Normal-Signallage können dann die Winkelfehler Δα₁ bis Δα₁₃ durch Vergleich der Anlauf-Signallage mit der Normal-Signallage an den jeweiligen Flankenwechseln nFW bestimmt werden. Entsprechende Werte sind der Fig. 7 zu entnehmen. Die zugehörigen Korrekturwerte KOW, die gemäß einer ersten Ausführungsform der Erfindung den Winkelfehlern Δα₁ bis Δα₁₃ entsprechen, werden in dem nicht flüchtigen Speicher abgespeichert.

Bei einem erneuten Einschalten des Phasensensors, beziehungsweise der Brennkraftmaschine, werden dann die Phasensignale nicht nur um die Adaptionswerte χ adaptiert, sondern zusätzlich um die im Speicher abgelegten Korrekturwerte KOW derart korrigiert, dass nach dem erneuten Einschalten des Phasensensors, beziehungsweise der Brennkraftmaschine, ein verbessertes Phasensignal zur Verfügung steht, und insbesondere nach dem erneuten Einschalten wenigstens weitgehend die Normal-Signallage erreicht wird.

Bei dem in der Figur 1, 4 und 7 gezeigten Beispiel beträgt der korrigierte Nockenwellenwinkel beim erneuten Einschalten der Brennkraftmaschine dann NW_{KOR} = 57°, und zwar an sämtlichen Flankenwechseln vom Beginn der Kalibrierphase bis zu deren Ende. Es ergibt sich dann der in Figur 4 gezeigte Winkelfehlerverlauf 41', bei dem ein Winkelfehler von idealerweise 0° vorliegt. Daraus ergibt sich nach dem Start der Brennkraftmaschine beziehungsweise nach dem Einschalten des Phasensensors eine sehr genaue Lage der Nockenwelle. Insgesamt führt dies zu günstigen Abgaswerten beim Starten der Brennkraftmaschine.

Die derart adaptierte und korrigierte Anlauf-Signallage des Phasensignals zum Kurbelwellensignal wird beim wiederholt erneutem Starten mit der Normal-Signallage verglichen. Bei Abweichungen von der korrigierten Anlauf-Signallage von der zu erwartenden Normal-Signallage kann eine erneute Korrektur durchgeführt werden. Die hieraus sich ergebenden neuen Korrekturwerte können bei einem wiederum erneuten Starten der Brennkraftmaschine zur Korrektur der beim vorherigen Starten ermittelten Korrekturwerte herangezogen werden. Hierdurch ergibt sich bei mehreren, erneuten Startvorgängen jeweils ein verbessertes, korrigiertes Anlauf-Phasensignal. Die Korrektur des Phasensignals wird folglich durch mehrfaches Wiederholen der Adaption und Korrektur bei erneutem Einschalten verbessert und gelernt; insbesondere wird eine gleitende Mittelwertbildung durchgeführt.

Insgesamt können durch die nicht flüchtige Speicherung der Korrekturwerte die systematischen Winkelfehler beim erneuten Starten ausgeschlossen werden.

Um Speicherplatz im nicht flüchtigen Speicher zu sparen, kann gemäß einer zweiten Ausführungsform der Erfindung die Korrektur durch Verwendung von für die Winkelfehler charakteristische Korrekturwerten erfolgen. Dies kann insbesondere dadurch erfolgen, dass die Korrekturwerte durch eine an die Winkelfehler angenäherte Gerade abgebildet werden. Bei einem Auftreten eines Winkelfehlers von 2,5° entspricht die Gerade dann dem Signalverlauf 41 der Figur 3, zwischen Flankenwechsel zwei und zwölf. Die Gerade kann dabei über eine lineare Regression oder über zwei ausgewählte Punkte berechnet werden. Damit kann es genügen, lediglich die ausgewählten Werte im nicht flüchtigen Speicher zu halten, und nicht vierzehn oder mehr einzelne Korrekturwerte KOW.

Zur Plausibilisierung der Werte können noch zusätzliche Mechanismen eingesetzt werden, beispielsweise können Höchst- oder Untergrenzen für die Werte verwendet werden. Außerdem kann eine Mittelung von mehreren, zum Beispiel drei Geraden aus mehreren, zum Beispiel drei Adaptionsvorgängen erfolgen.

## Patentansprüche

1. Verfahren zur Bereitstellung eines verbesserten Phasensignals eines aktiven Phasensensors (23) einer Nockenwelle (15) einer Brennkraftmaschine unmittelbar nach dem Einschalten des Phasensensors und/oder der Brennkraftmaschine, wobei der Phasensensor (23) Winkelmarken (16, 17) eines drehfest mit der Nockenwelle (15) verbundenen Geberrads (14) abtastet und während des Anlaufens der Brennkraftmaschine einen Kallibiervorgang durchführt, und wobei ein Kurbelwellensensor (22) Winkelmarken (12, 13) eines drehfest mit der Kurbelwelle (11) verbundenen Geberrads (10) abtastet, **gekennzeichnet durch** folgende Schritte:
a) Nach dem ersten Einschalten des Phasensensors (23):
a.1) Ermitteln der Anlauf-Signallage des Phasensignals (S_{NW}) während des Kalibiervorgangs des Phasensensors auf der Basis des Kurbelwellensignals (S_{KW}) über mehrere Winkelmarken (16, 17) des Geberrads (14) der Nockenwelle (15) hinweg, wobei während des Kalibiervorgangs des Phasensensors das Phasensignals schrittweise um Adaptionswerte (χᵢ) korrigiert wird, bis die Normal-Signallage erreicht ist,
a.2) Ermitteln der Normal-Signallage des Phasensignals auf der Basis des Kurbelwellensignals (S_{KW}) nach dem Anlaufen und nach abgeschlossenem Kalibriervorgang,
a.3) Bestimmen von Winkelfehlern (Δαᵢ) aus der Differenz zwischen der Anlauf-Signallage und der Normal-Signallage;
a.4) Ablegen von auf den Winkelfehlern basierenden Korrekturwerten (KOW) in einem nicht flüchtigen Speicher;
b) Beim erneuten Einschalten des Phasensensors bzw. Brennkraftmaschine:
b.1) Korrigieren des Phasensignals (S_{NW}) während des Kalibiervorgangs um die Korrekturwerte (KOW), so dass nach dem erneuten Einschalten des Phasensensors ein verbessertes Phasensignal (S_{NW-KROR}, KW_{NWKOR}) zur Verfügung steht.

2. Verfahren nach Anspruch 1, **dadurch gekennzeichnet, dass** das Korrigieren des Phasensignals (S_{NW}) gemäß Schritt b.1) derart erfolgt, dass das korrigierte Phasensignal (S_{NW-KROR}) während des Kalibiervorgangs auf der Basis des Kurbelwellensignals eine korrigierte Anlauf-Signallage (41') ergibt, die im wesentlichen der Normal-Signallage entspricht.

3. Verfahren nach Anspruch 1 oder 2, **dadurch gekennzeichnet, dass** die Normal-Signallage gemäß Schritt a.1) dann erreicht ist, wenn eine im Phasensensor ablaufende Kalibrierphase abgeschlossen ist.

4. Verfahreh nach Anspruch 3, **dadurch gekennzeichnet, dass** im Phasensensor während der Kalibrierphase die Schaltschwelle in Abhängigkeit von dem erfassten Signal derart nachgeführt wird, dass sich die Schaltschwelle (SSW) an einem bestimmten Prozentsatz des maximalen Signalhubes vom Phasensensor erfassten Signals (WM) liegt.

5. Verfahren nach Anspruch 1, 2, 3 oder 4, **dadurch gekennzeichnet, dass** die Korrekturwerte aus einem maximalen Winkelfehler (Δα) an der ersten abgetasteten Winkelmarke und aus um die Adaptionswerte (χ) korrigierte weitere Winkelfehler (Δα1, Δα2, Δα3, ..., Δαn) an weiteren abgetasteten Winkelmarken gebildet werden.

6. Verfahren nach einem der vorhergehenden Ansprüche, **dadurch gekennzeichnet, dass** beim mehrfach erneuten Einschalten des Phasensensors bzw. der Brennkraftmaschine nach Schritt b.1) die korrigierte Anlauf-Signallage mit der auf den bereist gespeicherten Korrekturwerten beruhenden zu erwartenden Anlauf-Signallage verglichen wird und bei mehrfachem Wiederholen eine Mittelwertbildung, insbesondere eine gleitende Mittelwertbildung, der gemäß Schritt a.4) abzulegenden Korrekturwerte erfolgt.

7. Verfahren nach einem der vorhergehenden Ansprüche, **dadurch gekennzeichnet, dass** das Anlaufen über mehrere Arbeitsspiele des Verbrennungsmotors erfolgt und dass der Kalibriervorgang insbesondere nach maximal 8 Arbeitsspielen vollständig abgeschlossen ist.

8. Verfahren nach einem der vorhergehenden Ansprüche, **dadurch gekennzeichnet, dass** die schrittweise Adaption zwischen zwei benachbarten Winkelmarken gemäß Schritt a.1) auf einen maximalen Adaptionswert (γ) begrenzt ist, wobei dieser maximale Adaptionswert insbesondere im Bereich zwischen ±2° und ±0,1°, und insbesondere im Bereich von ±0,2° bis ±0,75° und insbesondere im Bereich von ±0,25° liegt.

9. Verfahren nach einem der vorhergehenden Ansprüche, **dadurch gekennzeichnet, dass** das Ablegen der Korrekturwerte in einem nicht flüchtigen Speicher der Motorsteuerung der Brennkraftmaschine und/oder in einem nicht flüchtigen Speicher des Phasensensors erfolgt.

10. Verfahren nach einem der vorhergehenden Ansprüche, **dadurch gekennzeichnet, dass** die Korrekturwerte von einer an die Winkelfehler angenäherten Geraden abgebildet werden.

11. Verfahren nach einem der vorhergehenden Ansprüche, **dadurch gekennzeichnet, dass** die Adaption um die Adaptionswerte(χ) gem. Schritt a.1) und/oder die Korrektur nach Schritt b.1) unter definierten Bedingungen der Nockenwelle erfolgt.

12. Verfahren nach einem der vorhergehenden Ansprüche, **dadurch gekennzeichnet, dass** aus den ermittelten Winkelfehlern bzw. der Korrekturwerte und dem bekannten typischen Verhalten des Phasengebers bei unterschiedlichen Luftspalten der Einfluss der Luftspaltabhängigkeit und/oder die Größe des Luftspalts zwischen dem Phasensensor und den Winkelmarken ermittelt wird und dass daraus entsprechende Diagnose- und/oder Korrekturfunktionen aufgesetzt werden.

13. Verfahren nach einem der vorhergehenden Ansprüche, das der Phasensensor in Hall oder Magneto-Resisitiver (MR, GMR) Technologie ausgeführt ist.

14. System zur Bereitstellung eines verbesserten Signals eines die Winkellage einer Nockenwelle eines Verbrennungsmotors erfassenden Phasensensors unmittelbar nach dem Einschalten des Phasensensors und/oder des Verbrennungsmotors, das zur Durchführung des Verfahrens nach einem der vorhergehenden Ansprüche geeignet ist, umfassend eine mit der Nockenwelle drehfest verbundenes Geberrad, ein die Drehstellung des Geberrads erfassenden Phasensensor, einen mit der Kurbelwelle drehfest verbundenes Kurbelwellenrad, einen die Drehstellung des Kurbelwellenrads erfassenden Kurbelwellensensor, eine die Signale des Phasensensors und des Kurbelwellensensor verarbeitende Motorsteuerung, wobei ein nicht flüchtiger Speicher zum Ablegen der Korrekturwerte vorgesehen ist.

15. System nach Anspruch 14, **dadurch gekennzeichnet, dass** der nicht flüchtige Speicher ein Dauerram-Speicher, insbesondere ein EEPROM oder ein Flash Speicher, ist.

16. System nach Anspruch 14 oder 15, **dadurch gekennzeichnet, dass** der nicht flüchtige Speicher in der Motorsteuerung angeordnet ist.

17. System nach Anspruch 14, 15 oder 16, **dadurch gekennzeichnet, dass** im nicht flüchtigen Speicher und/oder in der Motorsteuerung Kennlinien der Korrekturwerte abgelegt werden oder sind.

18. Motorsteuerung für eine Brennkraftmaschine, **dadurch gekennzeichnet, dass** sie zur Durchführung des Verfahrens nach einem der Ansprüche 1 bis 13 ausgebildet ist.

19. Computerprogramm mit Programmcode für eine Motorsteuerung nach Anspruch 18 bzw. für ein System nach einem der Ansprüche 14 bis 17, **dadurch gekennzeichnet, dass** der Programmcode ausgebildet ist zur Durchführung des Verfahrens nach einem der Ansprüche 1 bis 13.

20. Computerprogramm nach Anspruch 19, **dadurch gekennzeichnet, dass** der Programmcode auf einem computerlesbaren Datenträger abgespeichert ist.

## Claims

1. Method for providing an improved phase signal of an active phase sensor (23) of a camshaft (15) of an internal combustion engine directly after the phase sensor and/or the internal combustion engine has/have been switched on, wherein the phase sensor (23) scans angle marks (16, 17) of a signal transmitter wheel (14) which is connected in a rotationally fixed fashion to the camshaft (15), and said phase sensor (23) carries out a calibration process during the starting of the internal combustion engine, and wherein a crankshaft sensor (22) scans angle marks (12, 13) of a signal transmitter wheel (10) which is connected in a rotationally fixed fashion to the crankshaft (11), **characterized by** the following steps:
a) after the phase sensor (23) is first switched on:
a.1) acquisition of the starting signal position of the phase signal (S_{NW}) during the calibration process of the phase sensor on the basis of the crankshaft signal (S_{KW}) over a plurality of angle marks (16, 17) of the signal transmitter wheel (14) of the camshaft (15), wherein the phase signal is incrementally corrected with adaptation values (χᵢ) during the calibration process of the phase sensor, until the normal signal position is reached,
a.2) acquisition of the normal signal position of the phase signal on the basis of the crankshaft signal (S_{KW}) after the starting and after the calibration process has been terminated,
a.3) determination of angle errors (Δαᵢ) from the difference between the starting signal position and the normal signal position;
a.4) storage of correction values (KOW) based on the angle errors in a non-volatile memory;
b) when the phase sensor or internal combustion engine is switched on again:
b.1) correction of the phase signal (S_{NW}) by the correction values (KOW) during the calibration process with the result that an improved phase signal (S_{NW-KROR}, KW_{NWKOR}) is available after the phase sensor has been switched on again.

2. Method according to Claim 1, **characterized in that** the correction of the phase signal (S_{NW}) is carried out in accordance with step b.1) in such a way that during the calibration process the corrected phase signal (S_{NW-KROR}) yields, on the basis of the crankshaft signal, a corrected starting signal position (41') which corresponds essentially to the normal signal position.

3. Method according to Claim 1 or 2, **characterized in that** the normal signal position is reached according to step a.1) when a calibration phase occurring in the phase sensor has been terminated.

4. Method according to Claim 3, **characterized in that** during the calibration phase the switching threshold is adjusted in the phase sensor as a function of the acquired signal in such a way that the switching threshold (SSW) is at a specific percentage of the maximum signal deviation of the signal (WM) which is acquired by the phase sensor.

5. Method according to Claims 1, 2, 3 or 4,
**characterized in that** the correction values are formed from a maximum angle error (Δα) at the first scanned angle mark and from further angle errors (Δα¹, Δα², Δα³, ..., Δαⁿ), corrected by the adaptation values (χ), at further scanned angle marks.

6. Method according to one of the preceding claims,
**characterized in that** when the phase sensor or the internal combustion engine is switched on again repeatedly after step b.1) the corrected starting signal position is compared with the expected starting signal position which is based on the correction values which have already been stored, and in the case of multiple repetition a mean-value-forming process, in particular a sliding mean-value-forming process, of the correction values to be stored according to step a.4) is carried out.

7. Method according to one of the preceding claims,
**characterized in that** the starting is carried out over a plurality of working cycles of the internal combustion engine, and **in that** the calibration process is completely terminated, in particular, after a maximum of 8 working cycles.

8. Method according to one of the preceding claims,
**characterized in that** the incremental adaptation between two adjacent angle marks according to step a.1) is limited to a maximum adaptation value (γ), wherein this maximum adaptation value is, in particular, in the range between ± 2° and ± 0.1°, and in particular in the range from ± 0.2° to ± 0.75°, and in particular in the region of ± 0.25°.

9. Method according to one of the preceding claims,
**characterized in that** the correction values are stored in a non-volatile memory of the engine control system of the internal combustion engine and/or in a non-volatile memory of the phase sensor.

10. Method according to one of the preceding claims,
**characterized in that** the correction values are mapped by a straight line which is approximated to the angle errors.

11. Method according to one of the preceding claims,
**characterized in that** the adaptation is carried out by the adaptation values (χ) according to step a.1) and/or the correction is carried out according to step b.1) under defined conditions of the camshaft.

12. Method according to one of the preceding claims,
**characterized in that** the influence of the air gap dependence and/or the size of the air gap between phase sensor and the angle marks is acquired from the acquired angle errors or the correction values and the known typical behaviour of the phase signal transmitter with different air gaps, and **in that** corresponding diagnostic functions and/or correction functions are set up on this basis.

13. Method according to one of the preceding claims,
**characterized in that** the phase sensor is embodied using Hall or magneto-resistive (MR, GMR) technology.

14. System for making available an improved signal of a phase sensor which senses the angle position of a camshaft of an internal combustion engine, directly after the phase sensor and/or the internal combustion engine has been switched on, which system is suitable for carrying out the method according to one of the preceding claims, comprising a signal generator wheel which is connected in a rotationally fixed fashion to the camshaft, a phase sensor which senses the rotational position of the signal generator wheel, a crankshaft wheel which is connected in a rotationally fixed fashion to the crankshaft, a crankshaft sensor which senses the rotational position of the crankshaft wheel, and an engine controller which processes the signals of the phase sensor and of the crankshaft sensor, wherein a non-volatile memory is provided for storing the correction values.

15. System according to Claim 14, **characterized in that** the non-volatile memory is a non-volatile RAM memory, in particular an EEPROM or a flash memory.

16. System according to Claim 14 or 15, **characterized in that** the non-volatile memory is arranged in the engine controller.

17. System according to Claim 14, 15 or 16,
**characterized in that** characteristic curves of the correction values are stored or have been stored in the non-volatile memory and/or in the engine controller.

18. Engine controller for an internal combustion engine, **characterized in that** it is designed to carry out the method according to one of Claims 1 to 13.

19. Computer program with program code for an engine controller according to Claim 18 or for a system according to one of Claims 14 to 17, **characterized in that** the program code is designed to carry out the method according to one of Claims 1 to 13.

20. Computer program according to Claim 19,
**characterized in that** the program code is stored on a computer-readable data carrier.

## Revendications

1. Procédé pour faire délivrer un signal de phase amélioré par un détecteur actif de phase (23) d'un arbre à cames (15) d'un moteur à combustion interne immédiatement après le branchement du détecteur de phase et/ou du moteur à combustion interne,
le détecteur de phase (23) détectant des repères d'angle (16, 17) d'une roue émettrice (14) reliée à rotation solidaire à l'arbre à cames (15) et exécutant une opération d'étalonnage pendant le démarrage du moteur à combustion interne,
un détecteur (22) de vilebrequin détectant des repères d'angle (12, 13) d'une roue émettrice (10) reliée à rotation solidaire au vilebrequin (11),
**caractérisé par** les étapes suivantes :
a) après le premier branchement du détecteur de phase (23) :
a.1) détermination de la position au démarrage du signal de phase (S_{NW}) pendant l'opération d'étalonnage du détecteur de phase, sur base du signal (S_{KW}) de vilebrequin et par l'intermédiaire de plusieurs repères d'angle (16, 17) de la roue émettrice (14) de l'arbre à cames (15), le signal de phase étant corrigé pas-à-pas par des valeurs d'adaptation (χᵢ) pendant l'étape d'étalonnage du détecteur de phase jusqu'à ce que la position normale du signal soit atteinte,
a.2) détermination de la position normale du signal de phase sur base du signal de vilebrequin (S_{KW}) après le démarrage et lorsque l'opération d'étalonnage est terminée,
a.3) détermination d'erreurs d'angle (Δαᵢ) à partir de la différence entre la position du signal au démarrage et la position normale du signal et
a.4) placement de valeurs de correction (KOW) basées sur les erreurs d'angle dans une mémoire non volatile et
b) lors d'un nouveau branchement du détecteur de phase ou du moteur à combustion interne :
b.1) correction du signal de phase (S_{NW}) pendant l'étape d'étalonnage par les valeurs de correction (KOW) de telle sorte qu'après le nouveau branchement du détecteur de phase, on dispose d'un signal de phase (S_{NW-KROR}, KW_{NWKOR}) amélioré.

2. Procédé selon la revendication 1, **caractérisé en ce que** la correction du signal de phase (S_{NW}) de l'étape b.1) s'effectue par le fait que pendant l'opération d'étalonnage, le signal de phase corrigé (S_{NW-KROR}) délivre sur base du signal de vilebrequin une position de démarrage corrigée du signal (41') qui correspond essentiellement à la position normale du signal.

3. Procédé selon les revendications 1. ou 2,
**caractérisé en ce que** la position normale du signal de l'étape a.1) est atteinte lorsque la phase d'étalonnage qui se déroule dans le détecteur de phase est terminée.

4. Procédé selon la revendication 3, **caractérisé en ce que** pendant la phase d'étalonnage, le seuil de commutation est suivi dans le détecteur de phase en fonction du signal détecté de telle sorte que le seuil de commutation (SSW) soit situé à un pourcentage défini de la course maximale du signal (WM) détecté par le détecteur de phase.

5. Procédé selon les revendications 1, 2, 3 ou 4,
**caractérisé en ce que** les valeurs de correction sont formées d'une erreur maximale d'angle (Δα) sur le premier repère d'angle palpé et des autres erreurs d'angle (Δα¹, Δα², Δα³, ..., Δαⁿ) corrigées des valeurs d'adaptation (χ) sur les autres repères d'angle palpés.

6. Procédé selon l'une des revendications précédentes, **caractérisé en ce que** lorsque le détecteur de phase ou le moteur à combustion interne sont branchés plusieurs fois après l'étape b.1), la position corrigée du signal au démarrage est comparée à la position attendue du signal au démarrage qui repose sur les valeurs de correction déjà conservées en mémoire et **en ce qu'**en cas de répétitions multiples, une valeur moyenne et en particulier une valeur moyenne glissante est formée en fonction des valeurs de correction qui sont conservées à l'étape a.4).

7. Procédé selon l'une des revendications précédentes, **caractérisé en ce que** le démarrage s'effectue par plusieurs courses de travail du moteur à combustion interne et **en ce que** l'étape d'étalonnage est terminée complètement après au plus 8 courses de travail.

8. Procédé selon l'une des revendications précédentes, **caractérisé en ce que** l'adaptation pas-à-pas entre deux repères d'angle voisins à l'étape a.1) est limitée à une valeur maximale d'adaptation (γ), cette valeur maximale d'adaptation étant comprise en particulier dans la plage de ± 2° à ± 0,1°, en particulier dans la plage de ± 0,2° et ± 0,75° et en particulier autour de ± 0,25°.

9. Procédé selon l'une des revendications précédentes, **caractérisé en ce que** les valeurs de correction sont conservées dans une mémoire non volatile de la commande du moteur à combustion interne et/ou dans une mémoire non volatile du détecteur de phase.

10. Procédé selon l'une des revendications précédentes, **caractérisé en ce que** les valeurs de correction sont formées par une droite qui approche les erreurs d'angle.

11. Procédé selon l'une des revendications précédentes, **caractérisé en ce que** l'adaptation s'effectue autour des valeurs d'adaptation (χ) de l'étape a.1) et/ou de la correction de l'étape b.1) dans des conditions définies de l'arbre à cames.

12. Procédé selon l'une des revendications précédentes, **caractérisé en ce que** l'effet de la dépendance vis-à-vis de l'entrefer et/ou vis-à-vis de la taille de l'entrefer entre le détecteur de phase et les repères d'angle est déterminé à partir des erreurs d'angle déterminées et des valeurs de correction ainsi que du comportement typique connu de l'émetteur de phase pour différents entrefers et **en ce que** des fonctions de diagnostic et/ou de correction qui y correspondent sont ainsi définies.

13. Procédé selon l'une des revendications précédentes, **caractérisé en ce que** le détecteur de phase est réalisé par la technologie Hall ou la technologie magnéto-résistive (MR, GMR).

14. Système qui délivre un signal amélioré d'un détecteur de phase qui détecte la position angulaire de l'arbre à cames d'un moteur à combustion interne immédiatement après le branchement du détecteur de phase et/ou du moteur à combustion interne et qui convient pour exécuter le procédé selon l'une des revendications précédentes, comprenant une roue émettrice reliée à rotation solidaire à l'arbre à cames, un détecteur de phase qui détecte la position de rotation de la roue émettrice, une roue de vilebrequin reliée à rotation solidaire au vilebrequin, un détecteur de vilebrequin qui détecte la position de rotation de la roue de vilebrequin, une commande de moteur qui traite les signaux du détecteur de phase et du détecteur de vilebrequin et une mémoire non volatile prévue pour conserver les valeurs de correction.

15. Système selon la revendication 14, **caractérisé en ce que** la mémoire non volatile est une mémoire RAM permanente, en particulier une mémoire EEPROM ou une mémoire flash.

16. Système selon les revendications 14 ou 15,
**caractérisé en ce que** la mémoire non volatile est disposée dans la commande du moteur.

17. Système selon les revendications 14, 15 ou 16,
**caractérisé en ce que** des lignes caractéristiques des valeurs de correction sont conservées ou peuvent être conservées dans la mémoire volatile et/ou dans la commande du moteur.

18. Commande pour un moteur à combustion interne,
**caractérisée en ce qu'**elle est configurée en vue d'exécuter le procédé selon l'une des revendications 1 à 13.

19. Programme informatique doté d'un code de programme pour une commande de moteur selon la revendication 18 ou un système selon l'une des revendications 14 à 17,
**caractérisé en ce que** la code de programme est configuré pour exécuter le procédé selon l'une des revendications 1 à 13.

20. Programme informatique selon la revendication 19,
**caractérisé en ce que** le code de programme est conservé sur un support de données lisible par ordinateur.
